# EUROPEAN PATENT APPLICATION

(11) **EP 2 226 848 A1**
(43) Date of publication of application: **08.09.2010**
(21) Application number: 10154492.2
(22) Date of filing: 24.02.2010
(51) Int. Cl.: H01L 29/786, H01L 21/20

(54) **Thin film transistor, method of fabricating the same, and organic light emitting diode display device having the same**

(30) Priority: 03.03.2009 KR 20090018199
(71) Applicant: Samsung Mobile Display Co., Ltd., Yongin-city, Gyunggi-do 446-711 (KR)
(72) Inventor: Lee, Dong-Hyun, 446-711, Gyunggi-Do (KR); Lee, Ki-Yong, 446-711, Gyunggi-Do (KR); Seo, Jin-Wook, 446-711, Gyunggi-Do (KR); Yang, Tae-Hoon, 446-711, Gyunggi-Do (KR); Park, Byoung-Keon, 446-711, Gyunggi-Do (KR); Lee, Kil-Won, 446-711, Gyunggi-Do (KR); Lisachecnko, Maxim, 446-711, Gyunggi-Do (KR); Jung, Jae-Wan, 446-711, Gyunggi-Do (KR)
(74) Representative: Walaski, Jan Filip

(57) **Abstract**

A thin film transistor, a method of fabricating the same, and an organic light emitting diode display device having the same, the thin film transistor including: a substrate; a silicon layer formed on the substrate; a diffusion layer formed on the silicon layer; a semiconductor layer that is crystallized using a metal catalyst, formed on the diffusion layer; a gate electrode disposed on the diffusion layer, facing a channel region of the semiconductor layer; a gate insulating layer disposed between the gate electrode and the semiconductor layer; and source and drain electrodes electrically connected to source and drain regions of the semiconductor layer.

## Description

The present invention relates to a thin film transistor, a method of fabricating the same, and an organic light emitting diode display device having the same.

In general, polysilicon layers are widely used as semiconductor layers of thin film transistors, due to having high field effect mobility, and applicability to high-speed operation circuits and complementary metal-oxide semiconductor (CMOS) circuits. Thin film transistors including polysilicon layers are mainly used as active elements of active matrix liquid crystal displays and as switching devices, or driving elements, of organic light emitting diode display devices.

Methods of crystallizing amorphous silicon into polysilicon include a solid-phase crystallization method, an excimer laser crystallization method, a metal-induced crystallization method, and a metal-induced lateral crystallization method. In the solid-phase crystallization method, an amorphous silicon layer is annealed for from several hours, to tens of hours, at a temperature of about 700° C, or less, which is the deformation temperature of glass that is used as the substrate of a display device in which a TFT is used. In the excimer laser crystallization method, crystallization is carried out by irradiating an excimer laser onto an amorphous silicon layer, for a very short time, to locally heat the layer. In the metal-induced crystallization method, a phase change from an amorphous silicon layer into a polycrystalline silicon layer is induced by a metal, such as nickel, palladium, gold, or aluminum, by contacting the amorphous silicon layer with the metal, or by implanting the metal into the amorphous silicon layer. In the metal-induced lateral crystallization method, sequential crystallization of an amorphous silicon layer is induced, while a silicide generated by the reaction between metal and silicon propagates laterally.

However, the solid-phase crystallization method requires a long processing time and a long annealing time at a high temperature, so a substrate is disadvantageously apt to be deformed. The excimer laser crystallization method requires a costly laser apparatus and causes imperfections on a polycrystallized surface, providing an inferior interface between a semiconductor layer and a gate insulating layer.

Currently, in the method of crystallizing an amorphous silicon layer using a metal, crystallization can be advantageously performed for a shorter time and at a lower temperature than in the solid-phase crystallization method. Therefore, much research has been conducted on metal-induced crystallization methods. Crystallization methods using a metal include a metal-induced crystallization (MIC) method, a metal-induced lateral crystallization (MILC) method, and a super grain silicon (SGS) crystallization method.

One of the determining characteristics of a thin film transistor is a leakage current. In particular, in a semiconductor layer crystallized using a metal catalyst, the metal catalyst may remain in a channel region, and thus, increase a leakage current. Therefore, if the concentration of the metal catalyst remaining in the channel region is not controlled, the leakage current of the thin film transistor may increase, leading to degradation of the electrical characteristics thereof.

Aspects of the present invention provide a thin film transistor including a semiconductor layer that is crystallized using a metal catalyst, which has a reduced amount of residual metal catalyst remaining in the semiconductor layer, a method of fabricating the same, and an organic light emitting diode display device including the same.

In an exemplary embodiment of the present invention, provided is a thin film transistor that includes: a substrate; a silicon layer formed on the substrate; a diffusion layer formed on the silicon layer; a semiconductor layer formed on the diffusion layer, which is crystallized using a metal catalyst; a gate electrode disposed on a channel region of the semiconductor layer; a gate insulating layer disposed between the gate electrode and the semiconductor layer; and source and drain electrodes electrically connected to source and drain regions of the semiconductor layer.

In another exemplary embodiment of the present invention, provided is a method of fabricating the thin film transistor that includes: forming a silicon layer on a substrate; forming a diffusion layer on the silicon layer; forming an amorphous silicon layer on the diffusion layer; forming a metal catalyst layer on the amorphous silicon layer; annealing the substrate to convert the amorphous silicon layer into a polysilicon layer; removing the metal catalyst layer; patterning the amorphous silicon layer to form a semiconductor layer; forming a gate insulating layer on the substrate; forming a gate electrode that faces the semiconductor layer; forming an interlayer insulating layer on the substrate; and forming source and drain electrodes that are connected to the semiconductor layer.

In still another exemplary embodiment of the present invention, provided is an organic light emitting diode display device that includes: a substrate; a silicon layer formed on the substrate; a diffusion layer formed on the silicon layer; a semiconductor layer that is crystallized using a metal catalyst, formed on the diffusion layer; a gate electrode disposed on a channel region of the semiconductor layer; a gate insulating layer disposed between the gate electrode and the semiconductor layer; source and drain electrodes electrically connected to the semiconductor layer; a passivation layer disposed on the substrate; and a first electrode, an organic layer, and a second electrode disposed on the passivation layer and electrically connected to one of the source and drain electrodes, with the organic layer being disposed between the first and second electrodes.

Additional aspects and/or advantages of the invention will be set forth in part in the description which follows and, in part, will be obvious from the description, or may be learned by practice of the invention.

These and/or other aspects and advantages of the invention will become apparent and more readily appreciated from the following description of the exemplary embodiments, taken in conjunction with the accompanying drawings, in which:
FIGS. 1A to 1F are cross-sectional views of a thin film transistor, in accordance with an exemplary embodiment of the present invention;
FIG. 2 is a cross-sectional view of an organic light emitting diode display device, in accordance with an exemplary embodiment of the present invention;
FIG. 3A is a graph showing concentrations of a metal catalyst when a buffer layer is disposed under an amorphous silicon layer; and
FIG. 3B is a graph showing concentrations of a metal catalyst when a diffusion layer and a silicon layer are disposed under an amorphous silicon layer.

Reference will now be made in detail to the exemplary embodiments of the present invention, examples of which are illustrated in the accompanying drawings, wherein like reference numerals refer to the like elements throughout. The exemplary embodiments are described below, in order to explain the aspects of the present invention, by referring to the figures.

Herein, when a first element is referred to as being formed or disposed "on" a second element, the first element can be disposed directly on the second element, or one or more other elements may be disposed therebetween. When a first element is referred to as being formed or disposed "directly on" a second element, no other elements are disposed therebetween.

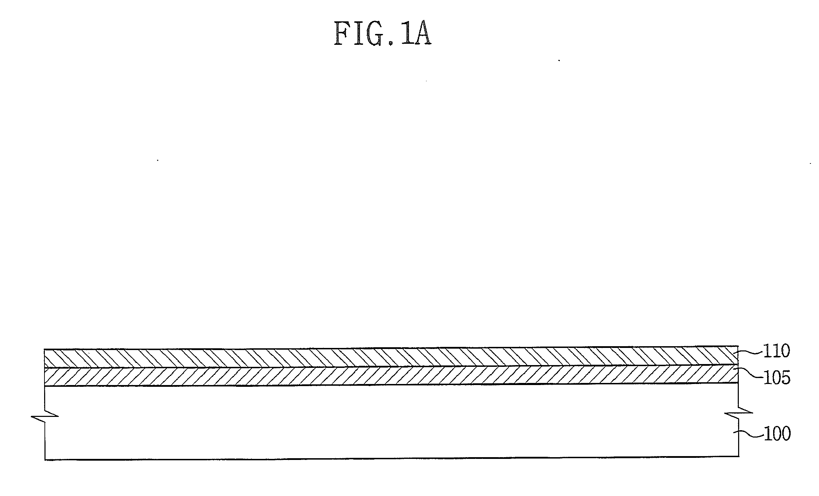

FIGS. 1A to 1F are cross-sectional views of a thin film transistor, in accordance with an exemplary embodiment of the present invention. Referring to FIG. 1A, a buffer layer 105 is formed on a glass or plastic substrate 100. The buffer layer 105 is an insulating layer, such as a silicon oxide layer or a silicon nitride layer, or multiple layers thereof. The buffer layer 105 can be formed using a chemical vapor deposition method or a physical vapor deposition method. The buffer layer 105 prevents the diffusion of moisture and/or impurities from the substrate 100, and/or adjusts a heat transfer rate to facilitate the crystallization of an amorphous silicon layer.

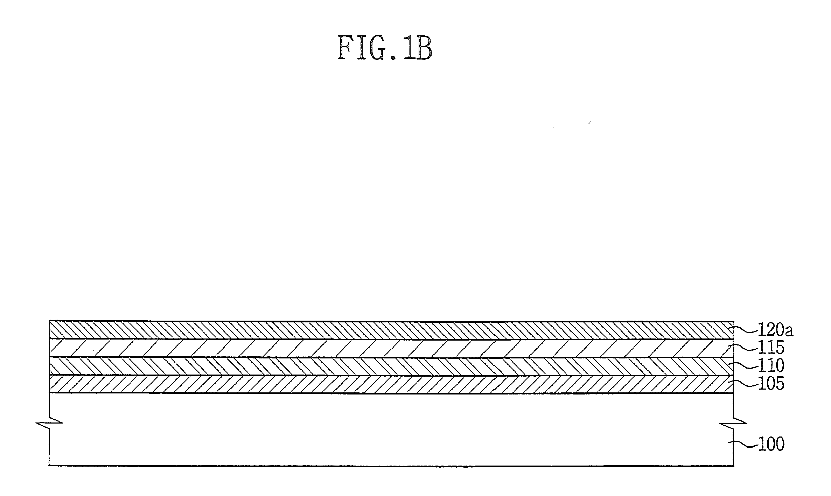

Referring to FIG. 1B, a silicon layer 110 is formed on the buffer layer 105. The silicon layer 110 is formed of amorphous silicon, using a chemical vapor deposition method or a physical vapor deposition method.

A diffusion layer 115 is formed on the silicon layer 110. The diffusion layer 115 may be formed of a silicon nitride layer, in which a metal catalyst can be diffused through an annealing process. The diffusion layer 115 may be formed of stacked silicon nitride and silicon oxide layers.

An amorphous silicon layer 120a is formed on the diffusion layer 115. The amorphous silicon layer 120a may be formed by a chemical vapor deposition method or a physical vapor deposition method. In addition, dehydrogenation may be performed during or after the formation of the amorphous silicon layer 120a, to reduce the concentration of hydrogen therein.

The amorphous silicon layer 120a is crystallized into a polysilicon layer (not shown), using metal catalyst a crystallization method. The method can be, for example, a metal-induced crystallization (MIC) method, a metal-induced lateral crystallization (MILC) method, or a super grain silicon (SGS) crystallization method.

Hereinafter, the SGS crystallization method will be described in detail. The SGS crystallization method is capable of reducing the concentration of a metal catalyst that is diffused into an amorphous silicon layer, to adjust the grain size produced thereby, to from several µm to several hundreds of µm. In order to reduce the concentration of the metal catalyst in the amorphous silicon layer, a metal catalyst layer may be formed on the diffusion layer, which is then annealed to diffuse the metal catalyst. The concentration of the metal catalyst may also be reduced without including the diffusion layer, by forming the metal catalyst layer at a low concentration, directly on the amorphous silicon layer.

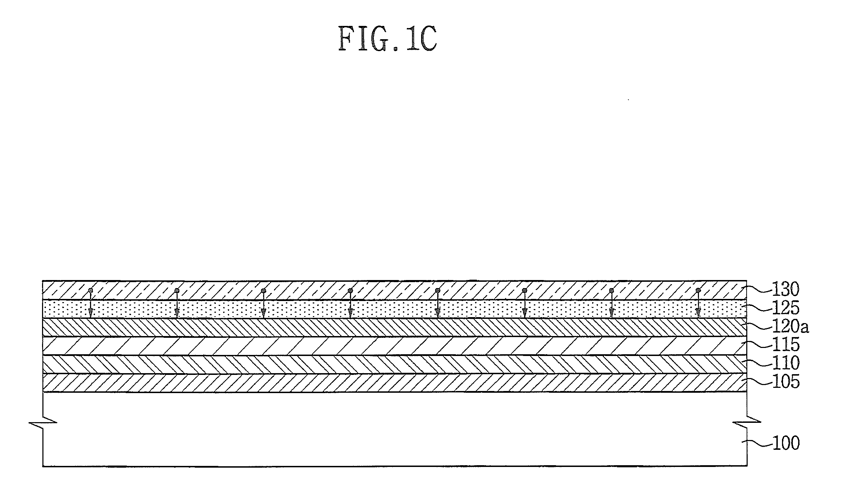

Referring to FIG. 1C, a capping layer 125 is formed on the amorphous silicon layer 120a. The capping layer 125 may be a silicon nitride layer, in which a metal catalyst can be diffused through annealing, or may include stacked silicon nitride and silicon oxide layers. The capping layer 125 can be formed by a chemical vapor deposition method or a physical vapor deposition method. The capping layer 125 may have a thickness of from about 0.1 to 200nm (2000 Å). When the thickness of the capping layer 125 is less than about 0.1nm (1 Å), it may be difficult to reduce the amount of the metal catalyst diffused in the capping layer 125. When the thickness of the capping layer 125 is larger than about 200nm (2000 Å), it may be difficult to crystallize the amorphous silicon layer 120a into the polysilicon layer, because the amount of the metal catalyst diffused into the amorphous silicon layer 120a is small.

A metal catalyst layer 130 is deposited on the capping layer 125. The metal catalyst layer 130 may be formed of a metal catalyst selected from the group consisting of Ni, Pd, Ag, Au, Al, Sn, Sb, Cu, Ti, and Cd. The metal catalyst layer 130 is generally formed with an areal density of from about 1011 to 1015 atoms/cm². When the areal density of the metal catalyst layer 130 is less than about 1011 atoms/cm², it may be difficult to crystallize the amorphous silicon layer 120a by SGS crystallization, because the amount of crystallization seeds is small. When the areal density of the metal catalyst layer 130 is more than about 1015 atoms/cm², the amount of the metal catalyst diffused into the amorphous silicon layer 120a is increased, reducing the grain size of the polysilicon layer formed from the amorphous silicon layer 120a. In addition, the amount of the metal catalyst remaining after crystallization is increased, which may deteriorate the characteristics of a semiconductor layer formed by patterning the polysilicon layer.

The substrate 100, on which the buffer layer 105, the silicon layer 110, the diffusion layer 115, the amorphous silicon layer 120a, the capping layer 125, and the metal catalyst layer 130 are formed, is annealed to diffuse some of the metal catalyst of the metal catalyst layer 130 into the surface of the amorphous silicon layer 120a. That is, the capping layer 125 acts to impede the diffusion of the metal catalyst into the surface of the amorphous silicon layer 120a.

Therefore, the amount of the metal catalyst diffused into the amorphous silicon layer 120a is determined by the diffusion characteristics of the diffusion layer 115 and the diffusion characteristics of the capping layer 125, which is closely related to the thickness of the capping layer 125. That is, an increase in thickness of the capping layer 125 reduces diffusion and increases the grain size of the resultant polysilicon layer, and a reduction in thickness of the capping layer 125 increases the diffusion and reduces the grain size of the polysilicon layer.

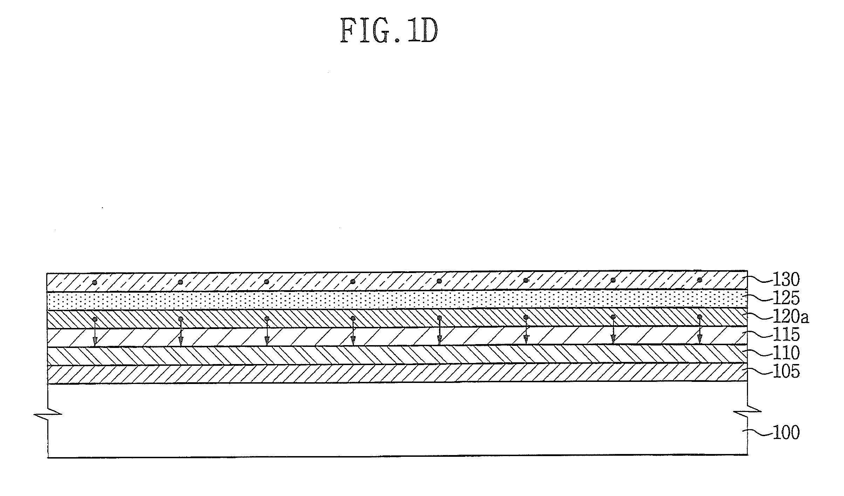

Referring to FIG. 1D, as the annealing continues, since the diffusion layer 115 and the silicon layer 110 are formed under the amorphous silicon layer 120a, the metal catalyst arriving at the amorphous silicon layer 120a is diffused into the diffusion layer 115 and the silicon layer 110. Therefore, the amount of the metal catalyst in the amorphous silicon layer 120a is reduced, to provide a gettering effect.

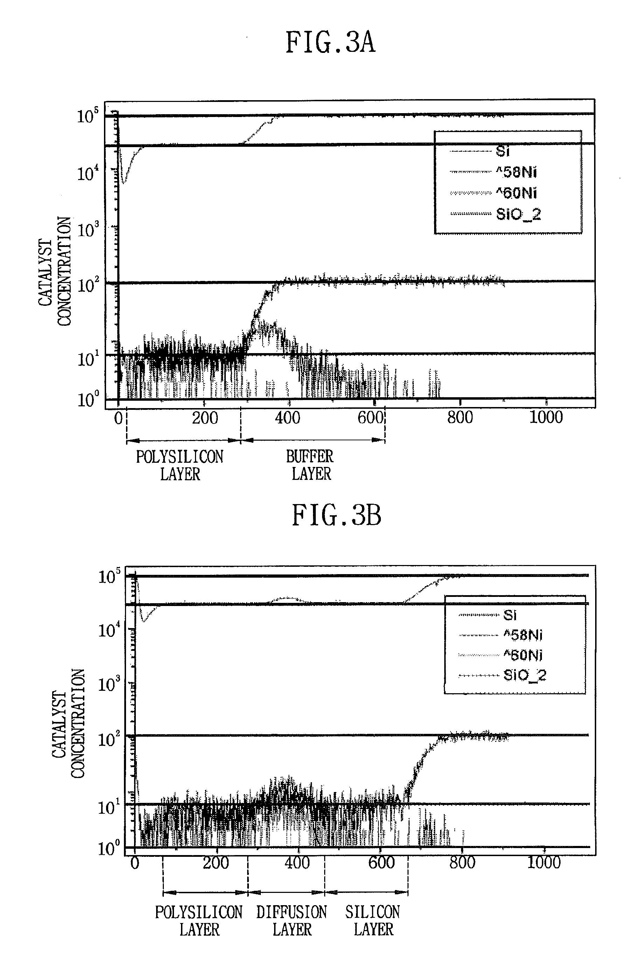

FIG. 3A is a graph showing the concentrations of a metal catalyst when only a buffer layer is disposed under an amorphous silicon layer, and FIG. 3B is a graph showing concentrations of a metal catalyst when a diffusion layer and a silicon layer are disposed under an amorphous silicon layer. Referring to FIGS. 3A and 3B, when the buffer layer is disposed under the polysilicon layer, which is crystallized by the metal catalyst of FIG. 3A, the metal catalyst is diffused into the buffer layer at a low concentration. However, referring to FIG. 3B, it will be appreciated that when the diffusion layer and the silicon layer are formed under the polysilicon layer, which is crystallized by the metal catalyst, the concentration of the catalyst in the polysilicon layer is lower than that of the polysilicon layer of FIG. 3A, and the concentration of the metal catalyst in the diffusion layer and the silicon layer is higher than that of the buffer layer. Therefore, it will be appreciated that the diffusion of the metal catalyst and the gettering effect are better, when a diffusion layer and a silicon layer are formed under a polysilicon layer.

Referring to FIG. 1D, the metal catalyst arriving at the silicon layer 110 is used to crystallize the silicon layer 110, in the same manner as in the crystallization of the amorphous silicon layer 120a into the polysilicon layer. The grains of the silicon layer 110 are secondary grains crystallized by the metal catalyst diffused from the amorphous silicon layer 120a. The grains of the silicon layer 110 are larger than the grains in the amorphous silicon layer 120a, have indistinct grain boundaries, and thus, are different from the grains of the amorphous silicon layer 120a.

The annealing is performed at a temperature of from about 200 to 900 °C, and in particular, from about 350 to 500 °C, for several seconds to several hours, to diffuse the metal catalyst. When the annealing is performed within the above ranges, it is possible to prevent deformation of the substrate 100, reduce manufacturing costs, and increase yields. The annealing may be one of a furnace process, a rapid thermal annealing (RTA) process, an ultraviolet (UV) process, and a laser process.

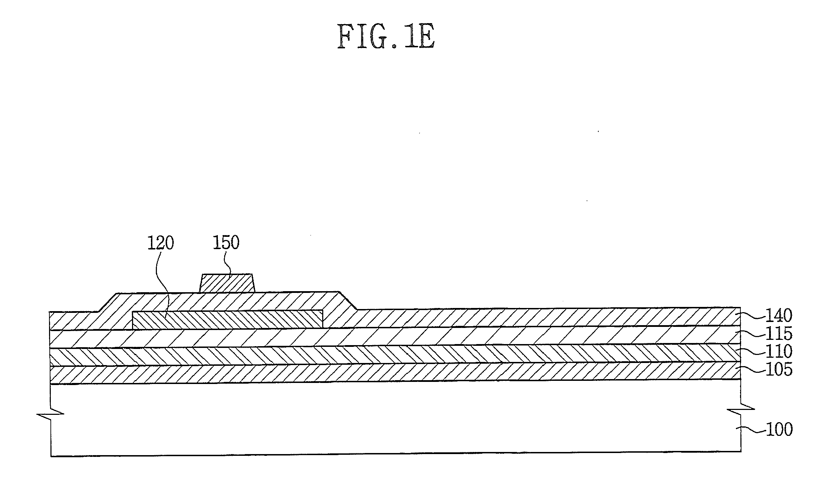

Referring to FIG. 1E, the polysilicon layer formed in the above manner is patterned to form a semiconductor layer 120. A gate insulating layer 140 is formed on the semiconductor layer 120 and the diffusion layer 115. Then a gate electrode 150 is formed on the gate insulating layer 140, adjacent to the semiconductor layer 120. The gate insulating layer 140 may include a silicon oxide layer, a silicon nitride layer, or stacked layers thereof.

A metal layer (not shown) is then formed on the gate insulating layer 140. The metal layer can be a single layer of aluminum (Al) or an aluminum alloy such as aluminum-neodymium (Al-Nd), or a multi-layer, in which an aluminum alloy is deposited on a chrome (Cr) or molybdenum (Mo) alloy. The metal layer is etched through a photolithography process, to form a gate electrode 150 that faces a portion of the semiconductor layer 120, the portion comprising a channel region in the finished thin film transistor.

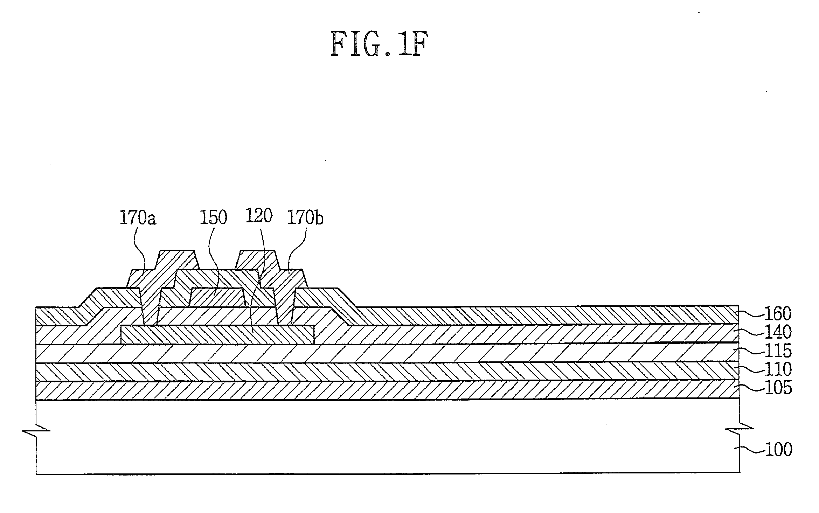

Referring to FIG. 1F, an interlayer insulating layer 160 is formed on the gate insulating layer 140 and the gate electrode 150. The interlayer insulating layer 160 may be a silicon nitride layer, a silicon oxide layer, or stacked layers thereof.

The interlayer insulating layer 160 and the gate insulating layer 140 are etched to form contact holes exposing portions of the semiconductor layer 120. Source and drain electrodes 170a and 170b are formed on the interlayer insulating layer 160 and connected to the source and drain regions through the contact holes, completing the thin film transistor. The source and drain electrodes 170a and 170b may be formed of one selected from molybdenum (Mo), chrome (Cr), tungsten (W), molybdenum tungsten (MoW), aluminum (Al), aluminum-neodymium (Al-Nd), titanium (Ti), titanium nitride (TiN), copper (Cu), a molybdenum (Mo) alloy, an aluminum (Al) alloy, and a copper (Co) alloy.

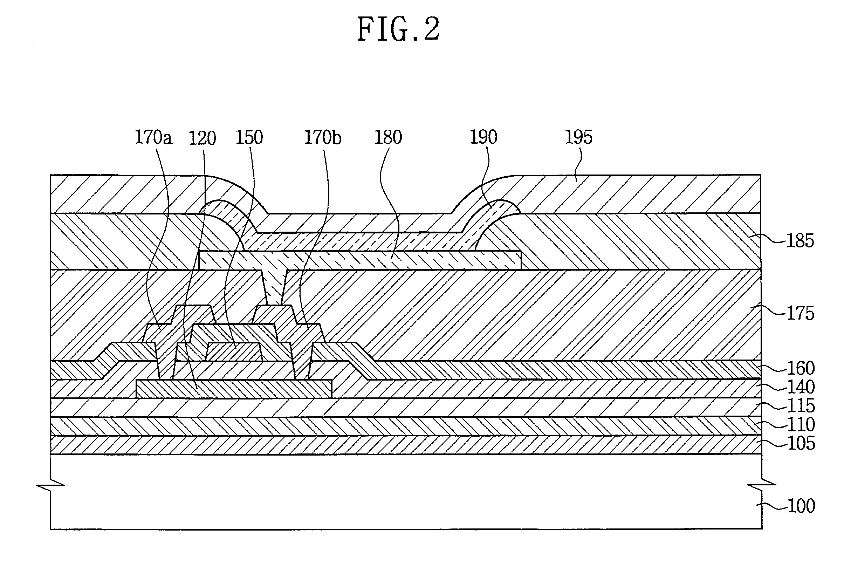

FIG. 2 is a cross-sectional view of an organic light emitting diode display device, in accordance with another exemplary embodiment of the present invention. The light emitting diode display device includes the thin film transistor of FIG. 1F, and thus, descriptions of similar elements are omitted. Referring to FIG. 2, a passivation layer 175 is formed on the source and drain electrodes 170a and 170b, and the interlayer insulating layer 160.

The passivation layer 175 may be an inorganic layer, such as a silicon oxide layer, a silicon nitride layer, or silicon on glass (SOG) layer. In the alternative, passivation layer 175 may be an organic layer, such as a polyimide layer, a benzocyclobutene series resin layer, or an acrylate layer. The passivation layer 175 may be a stack formed of the inorganic layer and the organic layer.

The passivation layer 175 is etched to form a hole exposing the drain electrode 170b. A first electrode 180 is connected to the drain electrode 170b, through the hole. The first electrode 180 may be referred to as an anode or a cathode. When the first electrode 180 is an anode, the anode may be a transparent conductive layer formed of one selected from indium tin oxide (ITO), indium zinc oxide (IZO), and indium tin zinc oxide (ITZO). When the first electrode 180 is a cathode, the cathode may be formed of Mg, Ca, Al, Ag, Ba, or an alloy thereof. In the alternative, the hole in the passivation layer 175 may expose the source electrode 170a, and the first electrode 180 may be connected to the source electrode 170a, via the hole.

A pixel defining layer 185, having an opening exposing the first electrode 180, is formed on the first electrode 180 and the passivation layer 175. An organic layer 190 is formed on the exposed first electrode 180. The organic layer 190 includes including an emission layer and may include at least one layer selected from a hole injection layer, a hole transport layer, a hole blocking layer, an electron blocking layer, an electron injection layer, and an electron transport layer. A second electrode 195 is formed on the organic layer 190. As a result, the organic light emitting diode display device is completed.

While the present invention has been described with reference to a thin film transistor and an organic light emitting diode display device having a top gate structure, the present invention may be applied to a thin film transistor having a bottom gate structure, including: a substrate; a gate electrode disposed on the substrate; a gate insulating layer disposed on the substrate; a silicon layer disposed on the substrate; a diffusion layer disposed on the silicon layer; a semiconductor layer disposed on the diffusion layer; and source and drain electrodes for opening a portion of the semiconductor layer and connected to the semiconductor layer, and an organic light emitting diode display device having the same.

Aspects of the present invention provide a thin film transistor having a semiconductor layer that is crystallized using a metal catalyst, a method of fabricating the same, and an organic light emitting diode display device having the same. The semiconductor layer has a larger grain size and a smaller amount of residual metal than a conventional semiconductor layer. As a result, the thin film transistor has an improved threshold voltage and Ioff characteristics.

Although aspects of the present invention have been described with reference to certain exemplary embodiments thereof, it will be understood by those skilled in the art that a variety of modifications and variations may be made to the exemplary embodiments of the present invention, without departing from the scope of the present invention, as defined in the appended claims.

## Claims

1. A thin film transistor comprising:
a substrate (100);
a silicon layer (110) disposed on the substrate;
a diffusion layer (115) disposed on the silicon layer;
a semiconductor layer (120) that is crystallized using a metal catalyst, disposed on the diffusion layer;
a gate electrode (150) disposed on the semiconductor layer;
a gate insulating layer (140) disposed between the gate electrode and the semiconductor layer; and
source and drain electrodes (170a, 170b) electrically connected to source and drain regions of the semiconductor layer, respectively.

2. The thin film transistor according to claim 1, wherein the silicon layer and the semiconductor layer are formed of polysilicon.

3. The thin film transistor according to claim 1 or 2, wherein the silicon layer and the semiconductor layer have different grain sizes.

4. The thin film transistor according to claim 1, 2 or 3, wherein the silicon layer, the semiconductor layer, and the diffusion layer comprise a metal catalyst.

5. The thin film transistor according to claim 4, wherein the metal catalyst is formed of one selected from the group consisting of Ni, Pd, Ag, Au, Al, Sn, Sb, Cu, Ti, and Cd.

6. The thin film transistor according to any one of the preceding claims, further comprising an interlayer insulating layer (160) disposed on the gate electrode, wherein the source and drain electrodes are insulated from the gate electrode by the interlayer insulating layer.

7. The thin film transistor according to any one of the preceding claims, wherein the source and drain electrodes are connected to the semiconductor layer, via openings formed in the gate insulating layer.

8. An organic light emitting diode (OLED) display device comprising:
a thin film transistor according to any one of the preceding claims; and
a passivation layer (175) disposed on the thin film transistor; and
a first electrode (180), an organic layer (190), and a second electrode (195) disposed on the passivation layer and electrically connected to one of the source and drain electrodes, the organic layer being disposed between the first and second electrodes.

9. A method of fabricating a thin film transistor, comprising:
forming a silicon layer (110) on a substrate (100);
forming a diffusion layer (115) on the silicon layer (110);
forming an amorphous silicon layer (120a) on the diffusion layer (115);
forming a metal catalyst layer (130) on the amorphous silicon layer (120a);
annealing the substrate to convert the amorphous silicon layer (120a) into a polysilicon layer (120);
removing the metal catalyst layer (130);
patterning the polysilicon layer to form a semiconductor layer (120);
forming a gate insulating layer (140) on the semiconductor layer (120);
forming a gate electrode (150) on the gate insulating layer (140), facing the semiconductor layer (120); and
forming source and drain electrodes (170a, 170b) that are connected to the semiconductor layer.

10. The method according to claim 9, further comprising forming an interlayer insulating layer (160) on the gate electrode (150).

11. The method according to claim 9 or 10, wherein the annealing is performed after forming a capping layer (125) between the amorphous silicon layer (120a) and the metal catalyst layer (130) for controlling diffusion of the metal catalyst into the surface of the amorphous silicon layer.

12. The method according to claim 11, wherein the capping layer is formed to have a thickness between about 0.1nm and 200nm.

13. The method according to any one of claims 9 to 12, wherein the annealing is performed at a temperature of from about 350 °C to about 500 °C.

14. The method according to any one of claims 9 to 13, wherein the metal catalyst layer is formed of one selected from the group consisting of Ni, Pd, Ag, Au, Al, Sn, Sb, Cu, Ti, and Cd.
